# EUROPEAN PATENT APPLICATION

(11) **EP 4 503 423 A1**
(43) Date of publication of application: **05.02.2025**
(21) Application number: 23774996.5
(22) Date of filing: 23.03.2023
(51) Int. Cl.: H02M 7/487, H02M 1/08

(54) **GATE DRIVE CIRCUIT, ELECTRIC POWER CONVERSION SYSTEM, AND GATE DRIVE METHOD**

(30) Priority: 24.03.2022 JP 2022048826
(71) Applicant: Panasonic Intellectual Property Management Co., Ltd., Kadoma-shi, Osaka 571-0057 (JP)
(72) Inventor: SUZUKI, Asamira, Kadoma-shi, Osaka 571-0057 (JP)
(74) Representative: Novagraaf International SA
(86) International application number: PCT/JP2023/011393
(87) International publication number: WO 2023/182402

(57) **Abstract**

The problem to be overcome by the present disclosure is to reduce the chances of causing any inconvenience while reducing an increase in circuit size. According to the present disclosure, a gate driver circuit (1) includes a signal generator (11), a signal interrupter (12), a first interlocker (15), a second interlocker (16), and a signal outputter (13). The signal interrupter (12) interrupts, on receiving an interruption signal, a first gate signal, a second gate signal, a third gate signal, and a fourth gate signal that are going to be applied from the signal generator (11) to a power converter circuit. The signal outputter (13) outputs the interruption signal to the signal interrupter (12) when the first gate signal and the second gate signal have high level and the third gate signal and the fourth gate signal have low level.

## Description

### Technical Field

The present disclosure generally relates to a gate driver circuit, a power conversion system, and a gate driving method. More particularly, the present disclosure relates to a gate driver circuit for controlling the ON/OFF states of switching elements, each including a gate terminal, a power conversion system including such a gate driver circuit, and a gate driving method for use in such a power conversion system.

### Background Art

Patent Literature 1 discloses a semiconductor power conversion apparatus including, for each phase, a pair of switching elements, of which the ON/OFF states are controlled to satisfy a mutually exclusive relationship with each other. The semiconductor power conversion apparatus of Patent Literature 1 further includes a gate interlocking circuit. When a gate reference signal applied to one of the pair of switching elements rises from zero to one while a gate feedback signal applied to the other switching element is zero, the gate interlocking circuit turns the one switching element from OFF to ON. In addition, once the one switching element has turned ON, the gate interlocking circuit keeps the one switching element ON until the gate reference signal falls from one to zero.

The semiconductor power conversion apparatus (power conversion system) of Patent Literature 1 may cause inconvenience depending on the combination of two or more switching elements which turn ON simultaneously and do not satisfy the mutually exclusive relationship with each other. In addition, in the semiconductor power conversion apparatus of Patent Literature 1, the gate interlocking circuit consists of only logic circuits, and therefore, may have a relatively large circuit size.

### Citation List

### Patent Literature

Patent Literature 1: JP 2009-27872 A

### Summary of Invention

An object of the present disclosure is to provide a gate driver circuit, a power conversion system, and a gate driving method, all of which have the ability to reduce the chances of causing any inconvenience while reducing an increase in the circuit size.

A gate driver circuit according to an aspect of the present disclosure controls the ON/OFF states of a first switching element, a second switching element, and a bidirectional switch which are included in a power converter circuit. The power converter circuit includes the first switching element, the second switching element, a first diode, a second diode, and the bidirectional switch. Each of the first switching element and the second switching element has a gate terminal. The first switching element and the second switching element are connected in series between a positive electrode and a negative electrode of a DC power supply. The first diode is connected in anti-parallel to the first switching element. The second diode is connected in anti-parallel to the second switching element. The bidirectional switch has a first gate terminal and a second gate terminal. The bidirectional switch has a first terminal connected to a connection node between the first switching element and the second switching element and has a second terminal connected to an intermediate potential node of the DC power supply. The gate driver circuit includes a signal generator, a signal interrupter, a first interlocker, a second interlocker, and a signal outputter. The signal generator generates a first gate signal to be applied to the gate terminal of the first switching element, a second gate signal to be applied to the gate terminal of the second switching element, a third gate signal to be applied to the first gate terminal of the bidirectional switch, and a fourth gate signal to be applied to the second gate terminal of the bidirectional switch. The signal interrupter interrupts, on receiving an interruption signal, the first gate signal, the second gate signal, the third gate signal, and the fourth gate signal that are going to be applied from the signal generator to the power converter circuit. The first interlocker controls the power converter circuit to prevent the first switching element and a third switching element, included in the bidirectional switch, from turning ON simultaneously. The second interlocker controls the power converter circuit to prevent the second switching element and a fourth switching element, included in the bidirectional switch, from turning ON simultaneously. The signal outputter outputs the interruption signal to the signal interrupter when the first gate signal and the second gate signal have high level and the third gate signal and the fourth gate signal have low level.

A power conversion system according to another aspect of the present disclosure includes the gate driver circuit described above and the power converter circuit.

A gate driving method according to still another aspect of the present disclosure is a method for controlling the ON/OFF states of a first switching element, a second switching element, and a bidirectional switch which are included in a power converter circuit. The power converter circuit includes the first switching element, the second switching element, a first diode, a second diode, and the bidirectional switch. Each of the first switching element and the second switching element has a gate terminal. The first switching element and the second switching element are connected in series between a positive electrode and a negative electrode of a DC power supply. The first diode is connected in anti-parallel to the first switching element. The second diode is connected in anti-parallel to the second switching element. The bidirectional switch has a first gate terminal and a second gate terminal. The bidirectional switch has a first terminal connected to a connection node between the first switching element and the second switching element and has a second terminal connected to an intermediate potential node of the DC power supply. The gate driving method includes a signal generating step, a signal interrupting step, a first interlocking step, a second interlocking step, and a signal outputting step. The signal generating step includes generating a first gate signal to be applied to the gate terminal of the first switching element, a second gate signal to be applied to the gate terminal of the second switching element, a third gate signal to be applied to the first gate terminal of the bidirectional switch, and a fourth gate signal to be applied to the second gate terminal of the bidirectional switch. The signal interrupting step includes interrupting, on receiving an interruption signal, the first gate signal, the second gate signal, the third gate signal, and the fourth gate signal that have been generated in the signal generating step to prevent the first, second, third, and fourth gate signals from being applied to the power converter circuit. The first interlocking step includes controlling the power converter circuit to prevent the first switching element and a third switching element, included in the bidirectional switch, from turning ON simultaneously. The second interlocking step includes controlling the power converter circuit to prevent the second switching element and a fourth switching element, included in the bidirectional switch, from turning ON simultaneously. The signal outputting step includes outputting the interruption signal when the first gate signal and the second gate signal have high level and the third gate signal and the fourth gate signal have low level.

### Brief Description of Drawings

FIG. 1 is a circuit diagram of a gate driver circuit according to an exemplary embodiment;
FIG. 2 is a circuit diagram of a drive circuit for use in the gate driver circuit;
FIG. 3 is a circuit diagram of power converter circuits for use in a power conversion system according to the exemplary embodiment; and
FIG. 4 is a flowchart of a gate driving method according to the exemplary embodiment.

### Description of Embodiments

### (Embodiments)

A gate driver circuit, a power conversion system, and a gate driving method according to an exemplary embodiment will now be described with reference to the accompanying drawings. The drawings to be referred to in the following description of embodiments are all schematic representations. Thus, the ratio of the dimensions (including thicknesses) of respective constituent elements illustrated on the drawings does not always reflect their actual dimensional ratio. Note that the exemplary embodiment to be described below is only an exemplary one of various embodiments of the present disclosure and should not be construed as limiting. Rather, the exemplary embodiment may be readily modified in various manners depending on a design choice or any other factor without departing from the scope of the present disclosure.

### (1) Overview

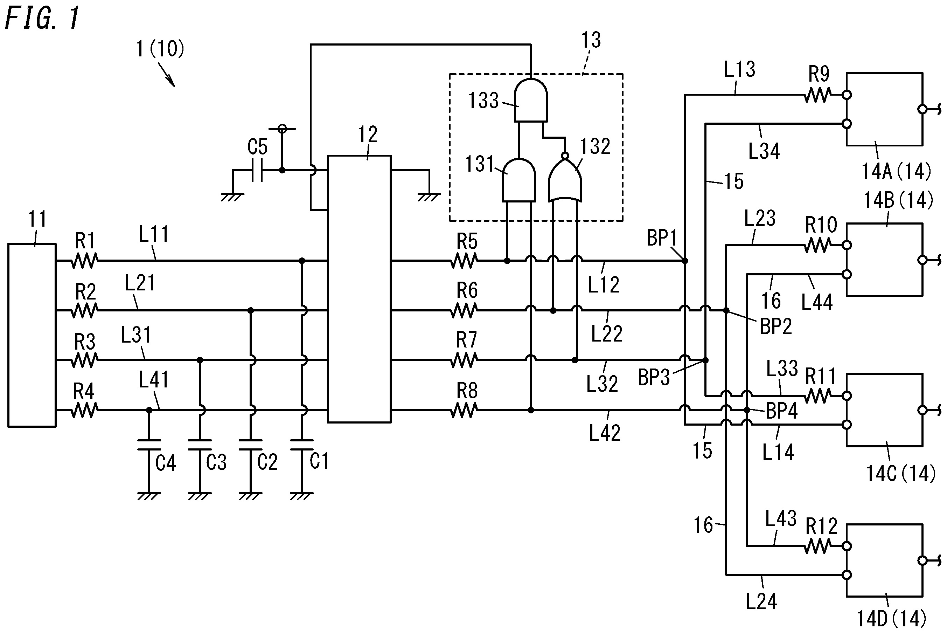

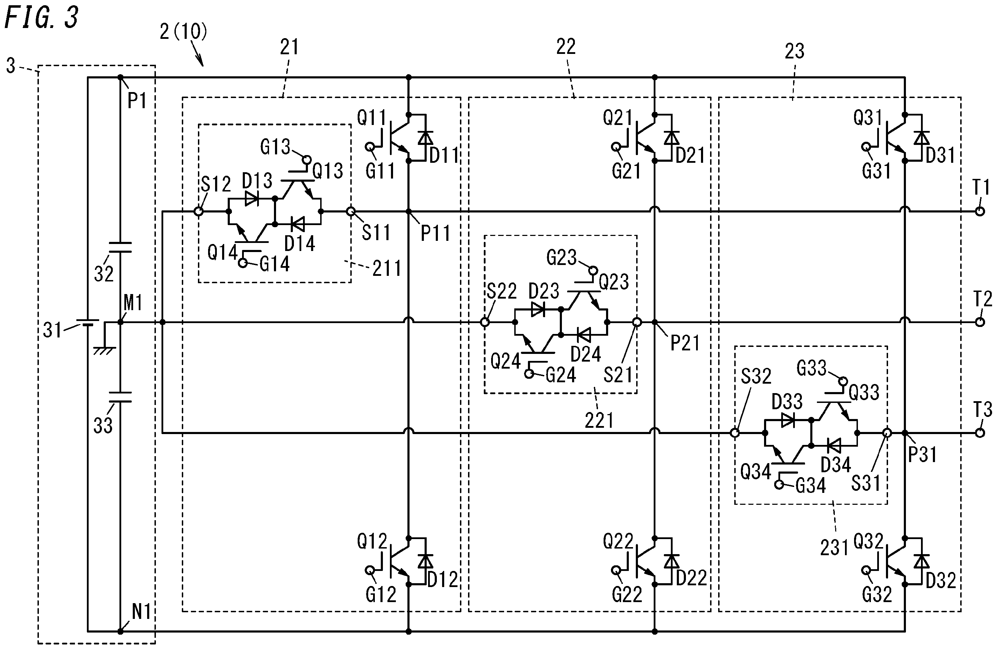

First of all, an overview of a gate driver circuit 1 and power conversion system 10 according to an exemplary embodiment will be described with reference to FIGS.1 and 3.

The gate driver circuit 1 shown in FIG. 1 is a circuit for controlling, for example, a power converter circuit 21 belonging to a plurality of power converter circuits 21-23 that form an inverter circuit 2 (refer to FIG. 3). More specifically, the gate driver circuit 1 is a circuit for controlling the ON/OFF states of a first switching element Q11, a second switching element Q12, and a bidirectional switch 211 which are included in the power converter circuit 21.

The inverter circuit 2 is a multi-level inverter, and more specifically, a three-level inverter of T type. A power conversion system 10 according to an exemplary embodiment includes the gate driver circuit 1 and the inverter circuit 2. That is to say, the power conversion system 10 includes the gate driver circuit 1 and the power converter circuit 21. In this embodiment, the power conversion system 10 includes a plurality of gate driver circuits 1 (only one of which is shown in FIG. 1) and a plurality of (e.g., three in the example illustrated in FIG. 3) power converter circuits 21-23. The plurality of gate driver circuits 1 and the plurality of power converter circuits 21-23 are arranged to correspond one to one. In other words, the power conversion system 10 according to the exemplary embodiment includes three gate driver circuits 1 for controlling the three power converter circuits 21-23, respectively.

The gate driver circuit 1 according to the exemplary embodiment is a gate driver circuit 1 for controlling the ON/OFF states of the first switching element Q11, the second switching element Q12, and the bidirectional switch 211 which are included in the power converter circuit 21.

The power converter circuit 21 includes the first switching element Q11, the second switching element Q12, a first diode D11, a second diode D12, and the bidirectional switch 211.

Each of the first switching element Q11 and the second switching element Q12 has a gate terminal G11, G12. The first switching element Q11 and the second switching element Q12 are connected in series between a positive electrode P1 and a negative electrode N1 of a DC power supply 3. The first diode D11 is connected in anti-parallel to the first switching element Q11. The second diode D12 is connected in anti-parallel to the second switching element Q12. The bidirectional switch 211 has a gate terminal G13 and a gate terminal G14. The bidirectional switch 211 has a first terminal (first main terminal S11) connected to a connection node P11 between the first switching element Q11 and the second switching element Q12 and has a second terminal (second main terminal S12) connected to an intermediate potential node M1 of the DC power supply 3.

The gate driver circuit 1 includes a signal generator 11, a signal interrupter 12, a first interlocker 15, a second interlocker 16, and a signal outputter 13.

The signal generator 11 generates a first gate signal to be applied to the gate terminal G11 of the first switching element Q11, a second gate signal to be applied to the gate terminal G12 of the second switching element Q12, a third gate signal to be applied to the gate terminal G13 of the bidirectional switch 211, and a fourth gate signal to be applied to the second gate terminal G14 of the bidirectional switch 211. The signal interrupter 12 interrupts, on receiving an interruption signal, the first gate signal, the second gate signal, the third gate signal, and the fourth gate signal that are going to be applied from the signal generator 11 to the power converter circuit 21. The first interlocker 15 controls the power converter circuit 21 to prevent the first switching element Q11 and a third switching element Q13, which is included in the bidirectional switch 211, from turning ON simultaneously. The second interlocker 16 controls the power converter circuit 21 to prevent the second switching element Q12 and a fourth switching element Q14, which is included in the bidirectional switch 211, from turning ON simultaneously. The signal outputter 13 outputs the interruption signal to the signal interrupter 12 when the first gate signal and the second gate signal have high level and the third gate signal and the fourth gate signal have low level.

In the gate driver circuit 1 according to this embodiment, the signal outputter 13 outputs the interruption signal to the signal interrupter 12 when the first gate signal and the second gate signal have high level and the third gate signal and the fourth gate signal have low level. Then, on receiving the interruption signal, the signal interrupter 12 interrupts the first gate signal, the second gate signal, the third gate signal, and the fourth gate signal that are going to be applied from the signal generator 11 to the power converter circuit 21. This allows the first switching element Q11, the second switching element Q12, the third switching element Q13, and the fourth switching element Q14 to be turned OFF in the situation described above. Consequently, this may reduce the chances of causing inconvenience in the situation described above. In addition, the gate driver circuit 1 according to this embodiment allows the signal outputter 13 to deal with the inconvenience that cannot be handled by the first interlocker 15 or the second interlocker 16. This enables reducing the circuit size of the signal outputter 13, thus eventually enabling reducing the overall size of the gate driver circuit 1. That is to say, the gate driver circuit 1 according to the exemplary embodiment may reduce the chances of causing inconvenience while reducing an increase in the circuit size of the gate driver circuit 1.

### (2) Details

Next, the gate driver circuit 1 and power conversion system 10 according to this embodiment will be described in detail with reference to FIGS. 1-3. Note that FIG. 1 shows only the gate driver circuit 1 provided for the power converter circuit 21 belonging to the plurality of power converter circuits 21-23 that form the inverter circuit 2 shown in FIG. 3 with illustration of the gate driver circuits for the power converter circuits 22, 23 omitted. Nevertheless, the gate driver circuits provided for the power converter circuits 22, 23 also have the same configuration as the gate driver circuit 1 provided for the power converter circuit 21.

The power conversion system 10 according to this embodiment includes a plurality of gate driver circuits 1 (only one of which is shown in FIG. 1) and a plurality of (e.g., three in the example illustrated in FIG. 3) power converter circuits 21-23 as described above. That is to say, the power conversion system 10 includes the plurality of gate driver circuits 1 and the plurality of power converter circuits 21-23. The plurality of gate driver circuits 1 and the plurality of power converter circuits 21-23 are arranged to correspond one to one. In this embodiment, three gate driver circuits 1 (only one of which is shown in FIG. 1) and three power converter circuits 21-23 are arranged to correspond one to one.

### (2.1) Gate driver circuit

As shown in FIG. 1, the gate driver circuit 1 includes the signal generator 11, the signal interrupter 12, the signal outputter 13, a plurality of (e.g., four in the example illustrated in FIG. 1) drive circuits 14, the first interlocker 15, and the second interlocker 16. In the following description, if there is any need to distinguish the plurality of drive circuits 14 from each other, the plurality of drive circuits 14 will be hereinafter sometimes referred to as "drive circuits 14A-14D."

### (2.1.1) Signal generator

The signal generator 11 generates the first gate signal, the second gate signal, the third gate signal, and the fourth gate signal. The first gate signal is a signal to be applied to the gate terminal G11 of the first switching element Q11. The second gate signal is a signal to be applied to the gate terminal G12 of the second switching element Q12. The third gate signal is a signal to be applied to the gate terminal G13 (first gate terminal) of the third switching element Q13 included in the bidirectional switch 211 (to be described later). The fourth gate signal is a signal to be applied to the gate terminal G14 (second gate terminal) of the fourth switching element Q14 included in the bidirectional switch 211 (to be described later).

Applying the first gate signal from the signal generator 11 to the gate terminal G11 of the first switching element Q11 allows the ON/OFF states of the first switching element Q11 to be controlled. Applying the second gate signal from the signal generator 11 to the gate terminal G12 of the second switching element Q12 allows the ON/OFF states of the second switching element Q12 to be controlled. Applying the third gate signal from the signal generator 11 to the gate terminal G13 of the third switching element Q13 allows the ON/OFF states of the third switching element Q13 to be controlled. Applying the fourth gate signal from the signal generator 11 to the gate terminal G14 of the fourth switching element Q14 allows the ON/OFF states of the fourth switching element Q14 to be controlled.

The signal generator 11 is connected to the signal interrupter 12 through a plurality of (e.g., four in the example illustrated in FIG. 1) first signal paths L11, L21, L31, L41. The first signal path L11 includes a resistor R1 and a capacitor C1 is connected between the first signal path L11 and the ground. The first signal path L21 includes a resistor R2 and a capacitor C2 is connected between the first signal path L21 and the ground. The first signal path L31 includes a resistor R3 and a capacitor C3 is connected between the first signal path L31 and the ground. The first signal path L41 includes a resistor R4 and a capacitor C4 is connected between the first signal path L41 and the ground.

The signal generator 11 outputs the first gate signal to the signal interrupter 12 (to be described later) via the first signal path L11. The signal generator 11 outputs the fourth gate signal to the signal interrupter 12 via the first signal path L21. The signal generator 11 outputs the third gate signal to the signal interrupter 12 via the first signal path L31. The signal generator 11 outputs the second gate signal to the signal interrupter 12 via the first signal path L41.

### (2.1.2) Signal interrupter

The signal interrupter 12 interrupts, on receiving an interruption signal from the signal outputter 13, the first gate signal, the second gate signal, the third gate signal, and the fourth gate signal that are going to be applied from the signal generator 11 to the power converter circuit 21. More specifically, on receiving the interruption signal from the signal outputter 13 (to be described later), the signal interrupter 12 outputs the first, second, third, and fourth gate signals each having low level even when receiving the second gate signal having high level from the signal generator 11, for example.

The signal interrupter 12 may be a level shifter, for example. In particular, in this embodiment, the signal interrupter 12 is a buffer. While receiving no interruption signals, the signal interrupter 12 shapes and amplifies the first, second, third, and fourth gate signals supplied from the signal generator 11 and then outputs the first, second, third, and fourth gate signals thus shaped and amplified to the plurality of drive circuits 14.

The signal interrupter 12 is connected to the signal outputter 13 through a plurality of (e.g., four in the example illustrated in FIG. 1) second signal paths L12, L22, L32, L42. The second signal path L12 is a signal path between the signal interrupter 12 and a branching node BP1 and includes a resistor R5. The second signal path L22 is a signal path between the signal interrupter 12 and a branching node BP2 and includes a resistor R6. The second signal path L32 is a signal path between the signal interrupter 12 and a branching node BP3 and includes a resistor R7. The second signal path L42 is a signal path between the signal interrupter 12 and a branching node BP4 and includes a resistor R8.

The second signal path L12 corresponds to the first signal path L11. The second signal path L22 corresponds to the first signal path L21. The second signal path L32 corresponds to the first signal path L31. The second signal path L42 corresponds to the first signal path L41.

### (2.1.3) Signal outputter

The signal outputter 13 outputs the interruption signal to the signal interrupter 12 when the first gate signal and the second gate signal have high level and the third gate signal and the fourth gate signal have low level. The signal interrupter 12 interrupts, on receiving the interruption signal from the signal outputter 13, the first gate signal, the second gate signal, the third gate signal, and the fourth gate signal that are going to be applied from the signal generator 11 to the power converter circuit 21 as described above. In other words, on receiving the interruption signal from the signal outputter 13, the signal interrupter 12 outputs the first, second, third, and fourth gate signals, each having low level.

More specifically, the signal outputter 13 includes a first AND circuit 131, a NOR circuit 132, and a second AND circuit 133 as shown in FIG. 1.

The first AND circuit 131 has a first input terminal connected to the second signal path L12 and has a second input terminal connected to the second signal path L42. Thus, the first AND circuit 131 receives the first gate signal and the second gate signal. The NOR circuit 132 has a first input terminal connected to the second signal path L22 and a second input terminal connected to the second signal path L32. Thus, the NOR circuit 132 receives the third gate signal and the fourth gate signal. The second AND circuit 133 has a first input terminal connected to the output terminal of the first AND circuit 131 and a second input terminal connected to the output terminal of the NOR circuit 132. Thus, the second AND circuit 133 receives the output signal of the first AND circuit 131 and the output signal of the NOR circuit 132.

When the first gate signal has high level, the second gate signal has high level, the third gate signal has low level, and the fourth gate signal has low level, the signal outputter 13 outputs a high-level interruption signal to the signal interrupter 12. Applying the high-level interruption signal to the signal interrupter 12 allows the first gate signal, the second gate signal, the third gate signal, and the fourth gate signal that are being applied from the signal generator 11 to the power converter circuit 21 to be interrupted. This allows the first switching element Q11, the second switching element Q12, the third switching element Q13, and the fourth switching element Q14 that form the power converter circuit 21 to be all turned OFF, thus reducing the chances of causing inconvenience such as short circuit.

Note that in the first through fourth modes (to be described later), the signal outputter 13 does not output the high-level interruption signal.

### (2.1.4) Drive circuit

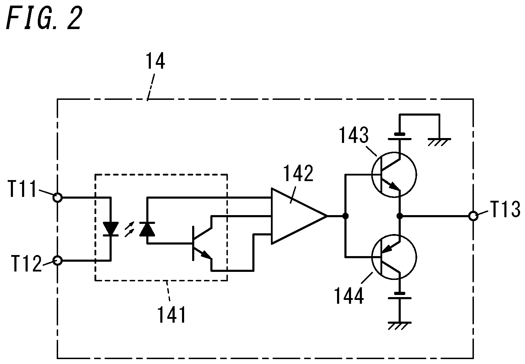

As shown in FIG. 2, the drive circuit 14 includes a photocoupler 141, a preamplifier 142, two transistors 143, 144, a pair of input terminals T11, T12, and an output terminal T13. The photocoupler 141 includes a light-emitting element, a photosensitive element, and a transistor. The light-emitting element may be, for example, a light-emitting diode (LED). The photosensitive element may be, for example, a photodiode. The light-emitting element of the photocoupler 141 is connected between the pair of input terminals T11, T12. More specifically, the light-emitting diode (light-emitting element) has an anode connected to the input terminal T11 and a cathode connected to the input terminal T12.

The preamplifier 142 has three input terminals (hereinafter referred to as a "first input terminal," a "second input terminal," and a "third input terminal," respectively) and an output terminal. The first input terminal of the preamplifier 142 is connected to the cathode of the photodiode (photosensitive element) of the photocoupler 141. The photodiode (photosensitive element) of the photocoupler 141 has an anode connected to the base terminal of the transistor of the photocoupler 141. The second input terminal of the preamplifier 142 is connected to the collector terminal of the transistor of the photocoupler 141. The third input terminal of the preamplifier 142 is connected to the emitter terminal of the transistor of the photocoupler 141. The output terminal of the preamplifier 142 is connected to the respective base terminals of the pair of transistors 143, 144.

The transistor 143 has a collector terminal connected to a positive electrode of a first power supply and has an emitter terminal connected to the emitter terminal of the transistor 144. The transistor 144 has a collector terminal connected to a negative electrode of a second power supply. The output terminal T13 is connected to a connection node between the transistors 143, 144.

In the drive circuit 14A, the output terminal T13 is connected to the gate terminal G11 of the first switching element Q11 of the power converter circuit 21. In the drive circuit 14B, the output terminal T13 is connected to the gate terminal G14 of the fourth switching element Q14 included in the bidirectional switch 211 of the power converter circuit 21. In the drive circuit 14C, the output terminal T13 is connected to the gate terminal G13 of the third switching element Q13 included in the bidirectional switch 211 of the power converter circuit 21. In the drive circuit 14D, the output terminal T13 is connected to the gate terminal G12 of the second switching element Q12 of the power converter circuit 21.

### (2.1.5) First interlocker

The first interlocker 15 controls the power converter circuit 21 to prevent the first switching element Q11 and the third switching element Q13 included in the bidirectional switch 211 from turning ON simultaneously. The first interlocker 15 has two second branch paths L14, L34 as shown in FIG. 1. The second branch path L14 branches from a branching node BP1 of the second signal path L12 and is connected to the drive circuit 14C. The second branch path L34 branches from a branching node BP3 of the second signal path L32 and is connected to the drive circuit 14A. Meanwhile, a first branch path L13, which is the other branch path branching from the branching node BP1, is connected to the drive circuit 14A via a resistor R9. A first branch path L33, which is the other branch path branching from the branching node BP3, is connected to the drive circuit 14C via a resistor R11.

For example, if the first gate signal has high level, the high-level first gate signal is supplied through the second branch path L14 to the drive circuit 14C as well, and therefore, the third switching element Q13 does not turn ON. If the third gate signal has high level, the high-level third gate signal is supplied through the second branch path L34 to the drive circuit 14A as well, and therefore, the first switching element Q11 does not turn ON. That is to say, the first interlocker 15 may reduce the chances of causing the inconvenience that the first switching element Q11 and the third switching element Q13 turn ON simultaneously.

### (2.1.6) Second interlocker

The second interlocker 16 controls the power converter circuit 21 to prevent the second switching element Q12 and the fourth switching element Q14 included in the bidirectional switch 211 from turning ON simultaneously. The second interlocker 16 has two second branch paths L24, L44 as shown in FIG. 1. The second branch path L24 branches from a branching node BP2 of the second signal path L22 and is connected to the drive circuit 14D. The second branch path L44 branches from a branching node BP4 of the second signal path L42 and is connected to the drive circuit 14B. Meanwhile, a first branch path L23, which is the other branch path branching from the branching node BP2, is connected to the drive circuit 14B via a resistor R10. A first branch path L43, which is the other branch path branching from the branching node BP4, is connected to the drive circuit 14D via a resistor R12.

For example, if the second gate signal has high level, the high-level second gate signal is supplied through the second branch path L44 to the drive circuit 14B as well, and therefore, the fourth switching element Q14 does not turn ON. If the fourth gate signal has high level, the high-level fourth gate signal is supplied through the second branch path L24 to the drive circuit 14D as well, and therefore, the second switching element Q12 does not turn ON. That is to say, the second interlocker 16 may reduce the chances of causing the inconvenience that the second switching element Q12 and the fourth switching element Q14 turn ON simultaneously.

### (2.2) Inverter circuit

The inverter circuit 2 is a three-level inverter of T type as described above. As shown in FIG. 3, the inverter circuit 2 includes a plurality of (e.g., three in the example illustrated in FIG. 3) power converter circuits 21-23. In this embodiment, each of these power converter circuits 21-23 has the same configuration. Thus, only the configuration of the power converter circuit 21 will be described below and the configuration of the other power converter circuits 22, 23 will not be described in the following description.

The power converter circuit 21 includes the first switching element Q11, the second switching element Q12, the first diode D11, the second diode D12, and the bidirectional switch 211. The power converter circuit 21 further includes an output terminal T1.

Each of the first switching element Q11 and the second switching element Q12 may be, for example, an insulated gate bipolar transistor (IGBT). The first switching element Q11 has the gate terminal G11, a collector terminal, and an emitter terminal. The second switching element Q12 has the gate terminal G12, a collector terminal, and an emitter terminal.

The first switching element Q11 and the second switching element Q12 are connected in series between the positive electrode P1 and negative electrode N1 of the DC power supply 3. More specifically, the first switching element Q11 and the second switching element Q12 are connected in series in this order in the direction pointing from the positive electrode P1 toward the negative electrode N1. More specifically, the first switching element Q11 has its collector terminal connected to the positive electrode P1 and its emitter terminal connected to the collector terminal of the second switching element Q12. The second switching element Q12 has its emitter terminal connected to the negative electrode N1.

In the first switching element Q11, the first gate signal supplied from the gate driver circuit 1 is applied to the gate terminal G11. In the second switching element Q12, the second gate signal supplied from the gate driver circuit 1 is applied to the gate terminal G12.

The first diode D11 is connected in anti-parallel to the first switching element Q11. More specifically, the first diode D11 has an anode connected to the emitter terminal of the first switching element Q11 and a cathode connected to the collector terminal of the first switching element Q11.

The second diode D12 is connected in anti-parallel to the second switching element Q12. More specifically, the second diode D12 has an anode connected to the emitter terminal of the second switching element Q12 and a cathode connected to the collector terminal of the second switching element Q12.

The bidirectional switch 211 is a dual-gate bidirectional device and is implemented as a dual-gate GaN-based gate injection transistor (GIT) in this embodiment. The bidirectional switch 211 has: a first gate terminal (gate terminal G13); a first main terminal S11 corresponding to the first gate terminal; a second gate terminal (gate terminal T14); and a second main terminal S12 corresponding to the second gate terminal.

The bidirectional switch 211 includes the third switching element Q13, the fourth switching element Q14, a third diode D13, and a fourth diode D14. Each of the third switching element Q13 and the fourth switching element Q14 may be, for example, an IGBT.

The third switching element Q13 has an emitter terminal connected to the first main terminal S11 and a collector terminal connected to the cathode of the third diode D13. The third diode D13 has an anode connected to the second main terminal S12.

The fourth switching element Q14 has an emitter terminal connected to the second main terminal S12 and a collector terminal connected to the cathode of the fourth diode D14. The fourth diode D14 has an anode connected to the first main terminal S11.

That is to say, the bidirectional switch 211 has the first gate terminal (gate terminal G13) and the second gate terminal (gate terminal G14), has the first terminal (first main terminal S11) thereof connected to the connection node P11 between the first switching element Q11 and the second switching element Q12, and has the second terminal (second main terminal S12) thereof connected to the intermediate potential node M1 of the DC power supply 3.

The output terminal T1 is connected to the connection node P11 between the first switching element Q11 and the second switching element Q12. The output terminal T11 is also connected to the first main terminal S11 of the bidirectional switch 211 via the connection node P11. The output terminal T1 is a terminal through which the voltage to be applied to the connection node P11 is output.

In this embodiment, a three-phase motor, for example, is connected to the three output terminals T1, T2, T3. That is to say, the inverter circuit 2 according to this embodiment is an inverter circuit for supplying three-phase AC power to a load (e.g., the three-phase motor in this embodiment).

### (2.3) DC power supply

The DC power supply 3 includes the main power supply 31 and two capacitors 32, 33 as shown in FIG. 3. The main power supply 31 may be, for example, a secondary battery or an electric double-layer capacitor. The two capacitors 32, 33 are connected in series across the main power supply 31, i.e., between the positive electrode P1 and negative electrode N1 of the main power supply 31. More specifically, these two capacitors 32, 33 are connected in series in this order in the direction pointing from the positive electrode P1 toward the negative electrode N1. In this embodiment, a connection node between the two capacitors 32, 33 is the intermediate potential node M1. As used herein, the "intermediate potential node M1" refers to a node, of which the potential is intermediate between the potential at the positive electrode P1 of the DC power supply 3 and the potential at the negative electrode N1 of the DC power supply 3. In this embodiment, the intermediate potential node M1 may have the ground potential, for example. For example, if the output voltage of a main power supply 31 is V1, then the potential at the positive electrode P1 is +V1/2 and the potential at the negative electrode N1 is -V1/2.

### (3) Basic operation of inverter circuit

Next, the basic operation of the inverter circuit 2 will be described. The plurality of power converter circuits 21-23 perform the same operation with their phases shifted from each other by 120 degrees. Thus, in the following description, only the operation of the power converter circuit 21 will be described and the operation of the other power converter circuits 22, 23 will not be described.

The power converter circuit 21 has the following first through fourth modes.

In the first mode, the first gate signal and the second gate signal have low level and the third gate signal or the fourth gate signal rises to high level. Thus, in the first mode, the first switching element Q11 and the second switching element Q12 turn OFF and the third switching element Q13 or the fourth switching element Q14 turns ON. As a result, the connection node P11 between the first switching element Q11 and the second switching element Q12 becomes electrically conductive with the intermediate potential node M1 via either the third switching element Q13 or the fourth switching element Q14, and therefore, the connection node P11 comes to have a potential of 0 V.

In the second mode, the second gate signal, the third gate signal, and the fourth gate signal have low level and the first gate signal rises to high level. Thus, in the second mode, the first switching element Q11 turns ON and the second switching element Q12, the third switching element Q13, and the fourth switching element Q14 turn OFF. As a result, the positive electrode P1 of the DC power supply 3 and the connection node P11 become electrically conductive with each other via the first switching element Q11, and therefore, the connection node P11 comes to have the same potential as the positive electrode P1. That is to say, if the output voltage of the main power supply 31 is V1, then the output terminal T1 comes to have a potential +V1/2.

In the third mode, the first gate signal and the second gate signal have low level and the third gate signal or the fourth gate signal rises to high level. Thus, in the third mode, the first switching element Q11 and the second switching element Q12 turn OFF and the third switching element Q13 or the fourth switching element Q14 turns ON. As a result, the connection node P11 between the first switching element Q11 and the second switching element Q12 becomes electrically conductive with the intermediate potential node M1 via either the third switching element Q13 or the fourth switching element Q14, and therefore, the connection node P11 comes to have a potential of 0 V.

In the fourth mode, the first gate signal, the third gate signal, and the fourth gate signal have low level and the second gate signal rises to high level. Thus, in the fourth mode, the second switching element Q12 turns ON and the first switching element Q11, the third switching element Q13, and the fourth switching element Q14 turn OFF. As a result, the negative electrode N1 of the DC power supply 3 and the connection node P11 become electrically conductive with each other via the second switching element Q12, and therefore, the output terminal T1 comes to have the same potential as the negative electrode N1. That is to say, if the output voltage of the main power supply 31 is V1, then the output terminal T1 comes to have a potential -V1/2.

The power converter circuit 21 according to this embodiment performs this series of operations in the first, second, third, and fourth modes repeatedly in this order. Likewise, each of the other power converter circuits 22, 23 also performs this series of operations in the first, second, third, and fourth modes repeatedly in this order with their phases shifted from each other by 120 degrees.

### (4) Gate driving method

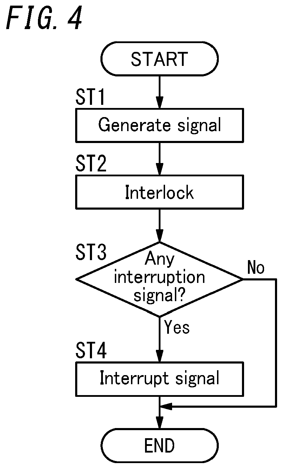

Next, a gate driving method according to this embodiment will be described with reference to FIG. 4.

The gate driving method according to this embodiment is a method for controlling the ON/OFF states of a first switching element Q11, a second switching element Q12, and a bidirectional switch 211 which are included in a power converter circuit 21.

The power converter circuit 21 includes the first switching element Q11, the second switching element Q12, a first diode D11, a second diode D12, and the bidirectional switch 211.

Each of the first switching element Q11 and the second switching element Q12 has a gate terminal G11, G12. The first switching element Q11 and the second switching element Q12 are connected in series between a positive electrode P1 and a negative electrode N1 of a DC power supply 3. The first diode D11 is connected in anti-parallel to the first switching element Q11. The second diode D12 is connected in anti-parallel to the second switching element Q12. The bidirectional switch 211 has a first gate terminal (gate terminal G13) and a second gate terminal (gate terminal G14). The bidirectional switch 211 has a first terminal (first main terminal S11) connected to a connection node P11 between the first switching element Q11 and the second switching element Q12 and has a second terminal (second main terminal S12) connected to an intermediate potential node M1 of the DC power supply 3.

The gate driving method includes a signal generating step ST1, a signal interrupting step ST4, an interlocking step ST2 (including a first interlocking step and a second interlocking step), and a signal outputting step ST3.

The signal generating step ST1 includes generating a first gate signal to be applied to the gate terminal G11 of the first switching element Q11, a second gate signal to be applied to the gate terminal G12 of the second switching element Q12, a third gate signal to be applied to the first gate terminal (gate terminal G13) of the bidirectional switch 211, and a fourth gate signal to be applied to the second gate terminal (gate terminal G14) of the bidirectional switch 211. The signal interrupting step ST4 includes interrupting, on receiving an interruption signal, the first gate signal, the second gate signal, the third gate signal, and the fourth gate signal that have been generated in the signal generating step ST1 to prevent the first, second, third, and fourth gate signals from being applied to the power converter circuit 21. The first interlocking step includes controlling the power converter circuit 21 to prevent the first switching element Q11 and a third switching element Q13, which is included in the bidirectional switch 211, from turning ON simultaneously. The second interlocking step includes controlling the power converter circuit 21 to prevent the second switching element Q12 and a fourth switching element Q14, which is included in the bidirectional switch 211, from turning ON simultaneously. The signal outputting step ST3 includes outputting the interruption signal when the first gate signal and the second gate signal have high level and the third gate signal and the fourth gate signal have low level.

In the gate driving method according to this embodiment, the signal outputting step ST3 includes outputting the interruption signal to the signal interrupter 12 when the first gate signal and the second gate signal have high level and the third gate signal and the fourth gate signal have low level. This allows, in the situation described above, the first switching element Q11, the second switching element Q12, and the third switching element Q13 and the fourth switching element Q14 that are included in the bidirectional switch 211 to be all turned OFF, thus reducing the chances of causing inconvenience in such a situation. In addition, the gate driving method according to this embodiment allows the signal outputting step ST3 to deal with the inconvenience that cannot be handled by the interlocking step ST2 (including the first interlocking step and the second interlocking step). This enables reducing the circuit size of the signal outputter 13, thus eventually enabling reducing the overall size of the gate driver circuit 1. That is to say, the gate driving method according to the exemplary embodiment may reduce the chances of causing inconvenience while reducing an increase in the circuit size of the gate driver circuit 1.

FIG. 4 is a flowchart of the gate driving method according to this embodiment. The gate driving method includes the respective steps ST1-ST4 shown in FIG. 4. Note that the flowchart shown in FIG. 4 is only an example and the order in which the respective steps are performed may be changed as appropriate. For example, the interlocking step ST2 and the signal outputting step ST3 may be performed in reverse order.

First, the gate driver circuit 1 performs a signal generating step ST1. In the signal generating step ST1, the signal generator 11 generates a first gate signal, a second gate signal, a third gate signal, and a fourth gate signal. As described above, the first gate signal is a signal to be applied to the gate terminal G11 of the first switching element Q11. The second gate signal is a signal to be applied to the gate terminal G12 of the second switching element Q12. The third gate signal is a signal to be applied to the gate terminal G13 of the third switching element Q13 included in the bidirectional switch 211. The fourth gate signal is a signal to be applied to the gate terminal G14 of the fourth switching element Q14 included in the bidirectional switch 211.

Next, the gate driver circuit 1 performs an interlocking step ST2. In the interlocking step ST2, the first interlocker 15 controls the power converter circuit 21 to prevent the first switching element Q11 and the third switching element Q13 from turning ON simultaneously (first interlocking step). More specifically, the first interlocker 15 outputs the first gate signal to the drive circuit 14C through the second branch path L14 and also outputs the third gate signal to the drive circuit 14A through the second branch path L34. In addition, in the interlocking step ST2, the second interlocker 16 controls the power converter circuit 21 to prevent the second switching element Q12 and the fourth switching element Q14 from turning ON simultaneously (second interlocking step). More specifically, the second interlocker 16 outputs the fourth gate signal to the drive circuit 14D through the second branch path L24 and also outputs the second gate signal to the drive circuit 14B through the second branch path L44.

Next, the gate driver circuit 1 performs a signal outputting step ST3. In the signal outputting step ST3, the signal outputter 13 outputs a high-level interruption signal to the signal interrupter 12 when the first gate signal and the second gate signal have high level and the third gate signal and the fourth gate signal have low level (if the answer is YES in ST3). On the other hand, if the answer is NO in the signal outputting step ST3 in the above-described situation, the signal outputter 13 ends the series of processing.

Next, if the answer is YES in ST3 in this situation, the gate driver circuit 1 performs a signal interrupting step ST4. In the signal interrupting step ST4, the signal interrupter 12 interrupts, in accordance with an interruption signal supplied from the signal outputter 13, the first gate signal, the second gate signal, the third gate signal, and the fourth gate signal that are going to be applied from the signal generator 11 to the power converter circuit 21. In other words, in the signal interrupting step ST4, the signal interrupter 12 outputs the first, second, third, and fourth gate signal, each having low level, in accordance with the interruption signal supplied from the signal outputter 13.

### (5) Advantages

In the gate driver circuit 1 according to this embodiment, the signal outputter 13 outputs the interruption signal to the signal interrupter 12 when the first gate signal and the second gate signal have high level and the third gate signal and the fourth gate signal have low level. Then, on receiving the interruption signal, the signal interrupter 12 interrupts the first gate signal, the second gate signal, the third gate signal, and the fourth gate signal that are going to be applied from the signal generator 11 to the power converter circuit 21. This allows the first switching element Q11, the second switching element Q12, the third switching element Q13, and the fourth switching element Q14 to be all turned OFF in the situation described above. Consequently, this may reduce the chances of causing inconvenience in the situation described above. In addition, the gate driver circuit 1 according to this embodiment allows the signal outputter 13 to deal with the inconvenience that cannot be handled by the first interlocker 15 or the second interlocker 16. This enables reducing the circuit size of the signal outputter 13, thus eventually enabling reducing the overall circuit size of the gate driver circuit 1. That is to say, the gate driver circuit 1 according to the exemplary embodiment may reduce the chances of causing inconvenience while reducing an increase in the circuit size of the gate driver circuit 1.

In the gate driver circuit 1 according to this embodiment, the signal outputter 13 includes the first AND circuit 131, the NOR circuit 132, and the second AND circuit 133. As can be seen, the signal outputter 13 consists of only logic circuits, thus enabling reducing, using a simple configuration, the chances of causing inconvenience.

The power conversion system 10 according to this embodiment includes a plurality of gate driver circuits 1 (only one of which is shown in FIG. 1) and a plurality of (e.g., three in the example illustrated in FIG. 3) power converter circuits 21-23. This enables generating AC power in multiple phases (e.g., in three phases).

In the power conversion system 10 according to this embodiment, each of the first switching element Q11, the second switching element Q12, the third switching element Q13, and the fourth switching element Q14 is an insulated gate bipolar transistor. This enables using the power conversion system 10 with a large amount of current supplied while contributing to reducing the size of the power conversion system 10.

### (6) Variations

Note that the embodiment described above is only an exemplary one of various embodiments of the present disclosure and should not be construed as limiting. Rather, the exemplary embodiment may be readily modified in various manners depending on a design choice or any other factor without departing from the scope of the present disclosure. Next, variations of the exemplary embodiment will be enumerated one after another. Note that the variations to be described below may be adopted in combination as appropriate.

The inverter circuit 2 does not have to include the three power converter circuits 21-23. Alternatively, the inverter circuit 2 may include only one power converter circuit or two power converter circuits. In that case, only one gate driver circuit or two gate driver circuits may be provided.

The configuration for the signal outputter 13 shown in FIG. 1 is only an example. Alternatively, the signal outputter 13 may also have any other configuration as long as the signal outputter 13 may interrupt all of the first, second, third, and fourth gate signals in the situation described above.

Each of the first switching element Q11, the second switching element Q12, the third switching element Q13, and the fourth switching element Q14 does not have to be an IGBT but may also be, for example, an SiC-MOSFET (silicon carbide metal-oxide semiconductor field effect transistor).

### (Aspects)

The foregoing description provides specific implementations for the following aspects of the present disclosure.

A gate driver circuit (1) according to a first aspect controls the ON/OFF states of a first switching element (Q11), a second switching element (Q12), and a bidirectional switch (211) which are included in a power converter circuit (21). The power converter circuit (21) includes the first switching element (Q11), the second switching element (Q12), a first diode (D11), a second diode (D12), and the bidirectional switch (211). Each of the first switching element (Q11) and the second switching element (Q12) has a gate terminal (G11, G12). The first switching element (Q11) and the second switching element (Q12) are connected in series between a positive electrode (P1) and a negative electrode (N1) of a DC power supply (3). The first diode (D11) is connected in anti-parallel to the first switching element (Q11). The second diode (D12) is connected in anti-parallel to the second switching element (Q12). The bidirectional switch (211) has a first gate terminal (G13) and a second gate terminal (G14). The bidirectional switch (211) has a first terminal (first main terminal S11) connected to a connection node (P11) between the first switching element (Q11) and the second switching element (Q12) and has a second terminal (second main terminal S12) connected to an intermediate potential node (M1) of the DC power supply (3). The gate driver circuit (1) includes a signal generator (11), a signal interrupter (12), a first interlocker (15), a second interlocker (16), and a signal outputter (13). The signal generator (11) generates a first gate signal to be applied to the gate terminal (G11) of the first switching element (Q11), a second gate signal to be applied to the gate terminal (G12) of the second switching element (Q12), a third gate signal to be applied to the first gate terminal (G13) of the bidirectional switch (211), and a fourth gate signal to be applied to the second gate terminal (G14) of the bidirectional switch (211). The signal interrupter (12) interrupts, on receiving an interruption signal, the first gate signal, the second gate signal, the third gate signal, and the fourth gate signal that are going to be applied from the signal generator (11) to the power converter circuit (21). The first interlocker (15) controls the power converter circuit (21) to prevent the first switching element (Q11) and a third switching element (Q13), which is included in the bidirectional switch (211), from turning ON simultaneously. The second interlocker (16) controls the power converter circuit (21) to prevent the second switching element (Q12) and a fourth switching element (Q14), which is included in the bidirectional switch (211), from turning ON simultaneously. The signal outputter (13) outputs the interruption signal to the signal interrupter (12) when the first gate signal and the second gate signal have high level and the third gate signal and the fourth gate signal have low level.

This aspect may reduce the chances of causing inconvenience while reducing an increase in circuit size.

In a gate driver circuit (1) according to a second aspect, which may be implemented in conjunction with the first aspect, the signal outputter (13) includes a first AND circuit (131), a NOR circuit (132), and a second AND circuit (133). The first AND circuit (131) receives the first gate signal and the second gate signal. The NOR circuit (132) receives the third gate signal and the fourth gate signal. The second AND circuit (133) receives an output signal of the first AND circuit (131) and an output signal of the NOR circuit (132).

This aspect may reduce, using a simple circuit configuration, the chances of causing inconvenience.

A power conversion system (10) according to a third aspect includes the gate driver circuit (1) according to the first or second aspect and the power converter circuit (21).

This aspect may reduce the chances of causing inconvenience while reducing an increase in circuit size.

A power conversion system (1) according to a fourth aspect, which may be implemented in conjunction with the third aspect, includes a plurality of the gate driver circuits (1); and a plurality of the power converter circuits (21-23). The plurality of the gate driver circuits (1) and the plurality of the power converter circuits (21-23) are arranged to correspond one to one.

This aspect enables generating AC power in multiple phases.

In a power conversion system (1) according to a fifth aspect, which may be implemented in conjunction with the third or fourth aspect, each of the first switching element (Q11), the second switching element (Q12), the third switching element (Q13), and the fourth switching element (Q14) is an insulated gate bipolar transistor.

This aspect allows the power conversion system (10) to be used with a large amount of current supplied while contributing to reducing the size of the power conversion system (10).

A gate driving method according to a sixth aspect is a method for controlling the ON/OFF states of a first switching element (Q11), a second switching element (Q12), and a bidirectional switch (211) which are included in a power converter circuit (21). The power converter circuit (21) includes the first switching element (Q11), the second switching element (Q12), a first diode (D11), a second diode (D12), and the bidirectional switch (211). Each of the first switching element (Q11) and the second switching element (Q12) has a gate terminal (G11, G12). The first switching element (Q11) and the second switching element (Q12) are connected in series between a positive electrode (P1) and a negative electrode (N1) of a DC power supply (3). The first diode (D11) is connected in anti-parallel to the first switching element (Q11). The second diode (D12) is connected in anti-parallel to the second switching element (Q12). The bidirectional switch (211) has a first gate terminal (G13) and a second gate terminal (G14). The bidirectional switch (211) has a first terminal (first main terminal S11) connected to a connection node (P11) between the first switching element (Q11) and the second switching element (Q12) and has a second terminal (second main terminal S12) connected to an intermediate potential node (M1) of the DC power supply (3). The gate driving method includes a signal generating step (ST1), a signal interrupting step (ST4), a first interlocking step (ST2), a second interlocking step (ST2), and a signal outputting step (ST3). The signal generating step (ST1) includes generating a first gate signal to be applied to the gate terminal (G11) of the first switching element (Q11), a second gate signal to be applied to the gate terminal (G12) of the second switching element (Q12), a third gate signal to be applied to the first gate terminal (G13) of the bidirectional switch (211), and a fourth gate signal to be applied to the second gate terminal (G14) of the bidirectional switch (211). The signal interrupting step (ST4) includes interrupting, on receiving an interruption signal, the first gate signal, the second gate signal, the third gate signal, and the fourth gate signal that have been generated in the signal generating step (ST1) to prevent the first, second, third, and fourth gate signals from being applied to the power converter circuit (21). The first interlocking step (ST2) includes controlling the power converter circuit (21) to prevent the first switching element (Q11) and a third switching element (Q13), which is included in the bidirectional switch (211), from turning ON simultaneously. The second interlocking step (ST2) includes controlling the power converter circuit (21) to prevent the second switching element (Q12) and a fourth switching element (Q14), which is included in the bidirectional switch (211), from turning ON simultaneously. The signal outputting step (ST3) includes outputting the interruption signal when the first gate signal and the second gate signal have high level and the third gate signal and the fourth gate signal have low level.

This aspect may reduce the chances of causing inconvenience while reducing an increase in circuit size.

Note that the constituent elements according to the second aspect are not essential constituent elements for the gate driver circuit (1) but may be omitted as appropriate.

Note that the constituent elements according to the fourth and fifth aspects are not essential constituent elements for the power conversion system (10) but may be omitted as appropriate.

### Reference Signs List

- 1: Gate Driver Circuit
- 3: DC Power Supply
- 10: Power Conversion System
- 11: Signal Generator
- 12: Signal Interrupter
- 13: Signal Outputter
- 15: First Interlocker
- 16: Second Interlocker
- 21-23: Power Converter Circuit
- 131: First AND Circuit
- 132: NOR Circuit
- 133: Second AND Circuit
- 211: Bidirectional Switch
- D11: First Diode
- D12: Second Diode
- G11, G12: Gate Terminal
- G13: Gate Terminal (First Gate Terminal)
- G14: Gate Terminal (Second Gate Terminal)
- M1: Intermediate Potential Node
- N1: Negative Electrode
- P1: Positive Electrode
- P11: Connection Node
- Q11: First Switching Element
- Q12: Second Switching Element
- Q13: Third Switching Element
- Q14: Fourth Switching Element
- ST1: Signal Generating Step
- ST2: Interlocking Step (First Interlocking Step, Second Interlocking Step)
- ST3: Signal Outputting Step
- ST4: Signal Interrupting Step

## Claims

1. A gate driver circuit configured to control ON/OFF states of a first switching element, a second switching element, and a bidirectional switch which are included in a power converter circuit,
the power converter circuit including:
the first switching element and the second switching element, each of the first switching element and the second switching element having a gate terminal, the first switching element and the second switching element being connected in series between a positive electrode and a negative electrode of a DC power supply;
a first diode connected in anti-parallel to the first switching element;
a second diode connected in anti-parallel to the second switching element; and
the bidirectional switch having a first gate terminal and a second gate terminal, the bidirectional switch having a first terminal connected to a connection node between the first switching element and the second switching element and having a second terminal connected to an intermediate potential node of the DC power supply,
the gate driver circuit comprising:
a signal generator configured to generate a first gate signal to be applied to the gate terminal of the first switching element, a second gate signal to be applied to the gate terminal of the second switching element, a third gate signal to be applied to the first gate terminal of the bidirectional switch, and a fourth gate signal to be applied to the second gate terminal of the bidirectional switch;
a signal interrupter configured to interrupt, on receiving an interruption signal, the first gate signal, the second gate signal, the third gate signal, and the fourth gate signal that are going to be applied from the signal generator to the power converter circuit;
a first interlocker configured to control the power converter circuit to prevent the first switching element and a third switching element from turning ON simultaneously, the third switching element being included in the bidirectional switch;
a second interlocker configured to control the power converter circuit to prevent the second switching element and a fourth switching element from turning ON simultaneously, the fourth switching element being included in the bidirectional switch; and
a signal outputter configured to output the interruption signal to the signal interrupter when the first gate signal and the second gate signal have high level and the third gate signal and the fourth gate signal have low level.

2. The gate driver circuit of claim 1, wherein
the signal outputter includes:
a first AND circuit configured to receive the first gate signal and the second gate signal;
a NOR circuit configured to receive the third gate signal and the fourth gate signal; and
a second AND circuit configured to receive an output signal of the first AND circuit and an output signal of the NOR circuit.

3. A power conversion system comprising:
the gate driver circuit of claim 1 or 2; and
the power converter circuit.

4. The power conversion system of claim 3, comprising:
a plurality of the gate driver circuits; and
a plurality of the power converter circuits, wherein
the plurality of the gate driver circuits and the plurality of the power converter circuits are arranged to correspond one to one.

5. The power conversion system of claim 3 or 4, wherein
each of the first switching element, the second switching element, the third switching element, and the fourth switching element is an insulated gate bipolar transistor.

6. A gate driving method for controlling ON/OFF states of a first switching element, a second switching element, and a bidirectional switch which are included in a power converter circuit,
the power converter circuit including:
the first switching element and the second switching element, each of the first switching element and the second switching element having a gate terminal, the first switching element and the second switching element being connected in series between a positive electrode and a negative electrode of a DC power supply;
a first diode connected in anti-parallel to the first switching element;
a second diode connected in anti-parallel to the second switching element; and
the bidirectional switch having a first gate terminal and a second gate terminal, the bidirectional switch having a first terminal connected to a connection node between the first switching element and the second switching element and having a second terminal connected to an intermediate potential node of the DC power supply,
the gate driving method comprising:
a signal generating step including generating a first gate signal to be applied to the gate terminal of the first switching element, a second gate signal to be applied to the gate terminal of the second switching element, a third gate signal to be applied to the first gate terminal of the bidirectional switch, and a fourth gate signal to be applied to the second gate terminal of the bidirectional switch;
a signal interrupting step including interrupting, on receiving an interruption signal, the first gate signal, the second gate signal, the third gate signal, and the fourth gate signal that have been generated in the signal generating step to prevent the first, second, third, and fourth gate signals from being applied to the power converter circuit;
a first interlocking step including controlling the power converter circuit to prevent the first switching element and a third switching element from turning ON simultaneously, the third switching element being included in the bidirectional switch;
a second interlocking step including controlling the power converter circuit to prevent the second switching element and a fourth switching element from turning ON simultaneously, the fourth switching element being included in the bidirectional switch; and
a signal outputting step including outputting the interruption signal when the first gate signal and the second gate signal have high level and the third gate signal and the fourth gate signal have low level.
